# EUROPEAN PATENT SPECIFICATION

(11) **EP 4 517 821 B1**
(45) Date of publication and mention of the grant of the patent: **02.12.2026**
(21) Application number: 24190513.2
(22) Date of filing: 24.07.2024
(51) Int. Cl.: H10W 70/60, H10W 70/63, H10W 70/692, H10W 70/68

(54) **PACKAGING SUBSTRATE AND METHOD OF MANUFACTURING THE SAME**
VERPACKUNGSSUBSTRAT UND VERFAHREN ZU SEINER HERSTELLUNG
SUBSTRAT D'EMBALLAGE ET SON PROCÉDÉ DE FABRICATION

(30) Priority: 30.08.2023 US 202318458157
(43) Date of publication of application: 05.03.2025
(73) Proprietor: Absolics Inc., Covington, GA 30014 (US)
(72) Inventor: KIM, Sungjin, Covington, Georgia, 30014 (US)
(74) Representative: BCKIP Part mbB

(56) References cited:
- EP-A1- 3 474 639
- CN-A- 115 917 730
- KR-A- 20220 128 587
- US-A1- 2020 045 824
- US-A1- 2023 125 605

## Description

### Technical Field of the Invention

The embodiments relate to a packaging substrate and a method of manufacturing the packaging substrate, and more particularly, to a packaging substrate including a glass substrate and a method of manufacturing the same.

### Background Art

In manufacturing electronic components, implementing a circuit on a semiconductor wafer is called as a front-end (FE) process, assembling the wafer in a state of being usable in an actual product is called as a back-end (BE) process, and a packaging process is included in subsequent processes.

Four core technologies of semiconductor industry, which recently enabled rapid development of electronic products, include semiconductor technology, semiconductor packaging technology, manufacturing process technology, and software technology. Semiconductor technology has developed in various forms, such as nanoscale (submicron) line widths, 10 million cells or more, high-speed operation, large heat dissipation, and the like, but a relatively perfect packaging technology is not supported. Accordingly, the electrical performance of a semiconductor can sometimes be determined by the packaging technology and the electrical connection according to the packaging technology rather than performance of the semiconductor technology itself.

Although a ceramic or resin has been applied as a material of a packaging substrate, recently, research on applying silicon or glass for a high-end packaging substrate has been performed, and specifically, a packaging substrate having a cavity structure has been developed by applying a glass substrate.

Meanwhile, a re-distribution layer (RDL) in the packaging process refers to a generic technology of changing a position of a previously formed electrical terminal (for example: an Al pad) to an arbitrary position using a wafer level package (WLP) process technology. This RDL is used as a method of solving a design limitation in a semiconductor manufacturing process through a package, that is, is used in semiconductor chip stacking.

Related Art Documents include US Patent Laid-Open Application US 20230162992A1, Korean Patent Laid-Open Application No. 10-2014-008230.

Document EP 3 474 639 A1 discloses a method for manufacturing a component carrier having an embedded component. The method comprises providing a support structure; attaching an electronic component at a surface of the support structure; providing a core structure; forming a cavity within the core structure; partially filling the cavity with a predefined amount of filling material; positioning the support structure relative to the core structure in such a manner that the electronic component is transferred into the cavity and is dipped into the filling material; curing the filling material such that the component within the cavity is fixed to core structure; and removing the support structure.

Document US 2020 / 0 045 824 A1 discloses a method of manufacturing a circuit board. The circuit board includes a single-sided copper-clad base, a plurality of grooves defined in the base facing away from the copper-clad side for receiving electronic elements, wherein a depth of each of the grooves is equal to a thickness of the corresponding electronic element, the electronic elements fixed into their respective grooves, a plurality of holes defined in the laminating member to expose the electrodes of the electronic elements, and an electroplated layer formed on the surface of the embedded body, wherein the electroplated layer is electrically connected with the electrodes of the electronic elements.

Document US 2023 / 0 125 605 A1 discloses a semiconductor device. The semiconductor device includes a glass substrate including a first surface, a second surface opposite to the first surface, and a first side surface between the first surface and the second surface. The semiconductor device further includes wirings provided on the first and second surfaces, a first insulating film that covers the first surface, a second insulating film that covers the second surface, and a third insulating film that covers the first side surface, the third insulating film being continuous with at least one of the first and second insulating films.

Document KR 2022 0 128 587 A discloses a semiconductor package structure, method, device, and an electronic product. In the semiconductor package structure, package elements are fixed in recesses on a substrate in one-to-one correspondence. An active surface of the package elements faces the substrate. The package elements and a recess in which the same are located are separated by an insulating material. Each package element has a first pad located on the active surface. Surfaces facing away from the substrate of all first pads are coplanar. A redistribution layer is located on the side of the package element facing away from the substrate. A plurality of second pads are formed on a first surface of the redistribution layer. A plurality of third pads are formed on a second surface of the redistribution layer facing the first surface. The second pad electrically contacts the first pad in a one-to-one correspondence. A passivation layer is located on the side facing away from the substrate of the redistribution layer. The substrate is formed of a semiconductor material or an insulating material. The thermal expansion coefficients of the semiconductor material in the substrate and the package element are the same or approximate.

Document CN 115 917 730 A discloses a package substrate. The package substrate comprises: a glass substrate comprising a first surface and a second surface, wherein the second surface is a surface opposite to the first surface; a cavity unit forming a space inside the glass substrate; a cavity frame that divides the space into a plurality of regions; and a cavity element included in at least a portion of the cavity unit, in which the cavity frame may include a plurality of frame through-holes penetrating in a direction from one side portion to the other side portion.

### SUMMARY OF THE INVENTION

An object of the present invention is to provide a packaging substrate that alleviates undulation, which occurs when various types of elements are mounted, in a glass substrate and a packaging substrate in which a plurality of elements are mounted in the glass substrate, and a method of manufacturing the same.

Further, an object of the present invention is to provide a packaging substrate in which cavities of various depths are disposed corresponding to the design of elements having various heights, and a method of manufacturing the same.

In addition, an object of the present invention is to provide a method of forming a flat insulating layer on a glass substrate and forming a flat upper layer on the insulating layer.

To this end, the present invention provides a packaging substrate in accordance with claim 1 and a method of manufacturing a packaging substrate in accordance with claim 4.

According to the present invention, a packaging substrate includes a core layer, wherein the core layer includes a glass substrate including a first surface and a second surface facing each other, and at least three or more cavity portions each having an opening open in a direction toward the first surface or the second surface of the glass substrate and having different depths.

The three or more cavity portions has different depths.

The packaging substrate includes at least three or more cavity elements arranged in the cavity portions and having different heights, and an insulating layer incorporated into the cavity portion and disposed on the surface having the opening at the glass substrate.

A cavity portion according to the present invention includes a first cavity portion which is open and recessed in the direction toward the first surface and has a first depth, a second cavity portion which is open and recessed in the direction toward the first surface or the second surface and has a second depth, and a third cavity portion which has a third depth passing through the first surface and the second surface. The second depth is deeper than the first depth.

A first cavity element is arranged in the first cavity portion.

A second cavity element is arranged in the second cavity portion.

A third cavity element is arranged in the third cavity portion.

One or more connection electrodes are disposed on the first cavity element.

One or more connection electrodes are disposed on the second cavity element.

One or more connection electrodes are disposed on the third cavity element in the direction toward the first surface or the second surface.

One or more connection electrodes may be further disposed in a direction toward the second surface with the third cavity element therebetween.

Each of the connection electrodes may be disposed in a direction toward both the first surface and the second surface on the third cavity element.

According to an another aspect of the present invention, a method of manufacturing a packaging substrate includes: an operation of forming a plurality of defects of different degrees on a first surface of a glass substrate including the first and second surfaces facing each other; and an operation of etching the first surface to form at least three or more cavity portions having different depths.

The method further includes an operation of arranging and an operation of forming an insulating layer.

The operation of arranging is an operation which arranges cavity elements having different heights in the cavity portions.

The operation of forming an insulating layer is an operation which forms an insulating layer on the surface having the opening of the glass substrate.

The cavity elements arranged at the cavity portion has different heights.

The cavity portion includes a first cavity portion and a second cavity portion.

The first cavity portion is open and recessed in the direction toward the first surface and has a first depth, and the second cavity portion is open and recessed in the direction toward the first surface or the second surface and has a second depth. The second depth is deeper than the first depth.

The cavity element includes a first cavity element and a second cavity element. The first cavity elements are one or more elements arranged in the first cavity portion. The second cavity element are one or more elements arranged in the second cavity portion.

The manufacturing method of the packaging substrate further includes an operation of forming a connection electrode.

The operation of forming the connection electrode is an operation of forming one or more connection electrodes connected to the first connection electrode or the second connection electrode.

According to the present invention, the cavity portion includes a first cavity portion, a second portion, and a third cavity portion.

The first cavity portion has an opening toward the first surface and has a first depth.

The second cavity portion has an opening toward the first surface or the second surface and has a second depth. The second depth is deeper than the first depth.

The third cavity portion penetrate the first surface and the second surface and has a third depth.

Cavity elements include a first cavity element, a second cavity element, and a third cavity element. The first cavity element is arranged at the first cavity portion. The second cavity element is arranged at the second cavity portion. The third cavity element is arranged at the third cavity portion.

The operation of forming the connection electrode is an operation of forming one or more connection electrodes connected to each of the first connection electrode, the second connection electrode and the third connection electrode.

The operation of forming the connection electrode may form a further connection electrode for the first and second surfaces of the third cavity element to have connection electrodes at both surfaces.

### BRIEF DESCRIPTION OF THE DRAWINGS

The above and other objects, features and advantages of the present invention will become more apparent to those of ordinary skill in the art by describing in detail exemplary embodiments thereof with reference to the accompanying drawings, in which:
FIG. 1 is a conceptual diagram for describing a cross-sectional structure of a packaging substrate according to an embodiment;
FIG. 2 is a conceptual diagram for describing a cross-sectional structure of a packaging substrate according to another embodiment;
FIGS. 3 (a) and (b) are conceptual diagrams for respectively describing portions of the packaging substrate according to the embodiments in cross-sections;
FIG. 4 is a flow chart for describing a process of generating a core distribution layer in a packaging substrate manufacturing process according to the embodiment in cross-sections;
FIG. 5 is a flow chart for describing a process of generating an insulating layer in the packaging substrate manufacturing process according to the embodiment in cross-sections
FIGS. 6 (a) to (c) are views for describing portions of the packaging substrates not covered by the present invention in cross-sections;
FIGS. 7 (a) to (c) are views for describing portions of packaging substrates according to an embodiment of the present invention in cross-sections; and
FIG. 8 is a flow chart for describing the packaging substrate manufacturing process according to the present invention in cross-sections, wherein S1 is an operation of forming a plurality of defects, S2 is an operation of forming a cavity portion (an operation of etching), S3 is an operation of arranging, S4 is an operation of forming an insulating layer, and S5 is an operation of forming a connection electrode.

### DETAILED DESCRIPTION OF EXEMPLARY EMBODIMENTS

Hereinafter, embodiments will be described in detail with reference to the accompanying drawings, which may allow those skilled in the art to easily perform the present invention. The embodiments may be implemented in various forms and are not limited to embodiments described herein. Like reference numerals are used for like components throughout the specification.

Throughout the present specification, the term "combination thereof" included in expression of the Markush form refers to a mixture or combination of one or more selected from a group consisting of components disclosed in the expression of the Markush form, and refers to including the one or more selected from the group consisting of the components.

Throughout the present specification, terms such as "first," "second" or "A," "B" are used to distinguish the same terms. Further, a singular form includes a plural form unless otherwise defined in the context.

In the present specification, "~-based" may refer to including a compound corresponding to "~" or a derivative of the "~" in the compound.

In the present specification, the expression B is located on A means that B is directly located on A or B is located on A while another layer is located therebetween, and is not interpreted as being limited to B being located on A while in contact therewith.

In the present specification, the expression B is connected to A means that B is directly connected to A or B is connected to A through another component therebetween, and is not interpreted as being limited to B being directly connected to A unless otherwise specifically mentioned.

In the present specification, a singular form is interpreted as a meaning including a singular form or plural form unless otherwise specifically described.

In a process of developing a semiconductor device capable of exhibiting high performance while being more integrated and having a thinner thickness, while recognizing that not only an element itself but also packaging is an important factor in performance improvement and researching this, the present inventors found that a packaging substrate may become relatively thinner and become helpful for improving the electrical characteristics of the semiconductor device by a method of applying a glass core as a single layer, applying a cavity structure, and the like unlike applying a core of two layers or more, such as a conventional interposer and an organic substrate, on a motherboard as a packaging substrate, and completed the invention.

Elements, which perform various functions, may be mounted in a cavity structure of a glass substrate, and accordingly, a thin packaging substrate may be formed. Since the elements mounted in the cavity structure have various sizes and heights according to the type thereof, in the same cavity structure, undulation due to a height difference between elements, that is, defects in the form of waves with curves or peaks and valleys may occur. This undulation has the possibility of affecting the lightening and thinning of the packaging substrate, and weakening electrical characteristics as well.

Accordingly, as a result of repeated research, when the cavity structure for mounting the elements in the glass substrate is formed, the invention was completed by identifying that undulation can be improved by adjusting an etching degree in consideration of the heights or sizes of the elements.

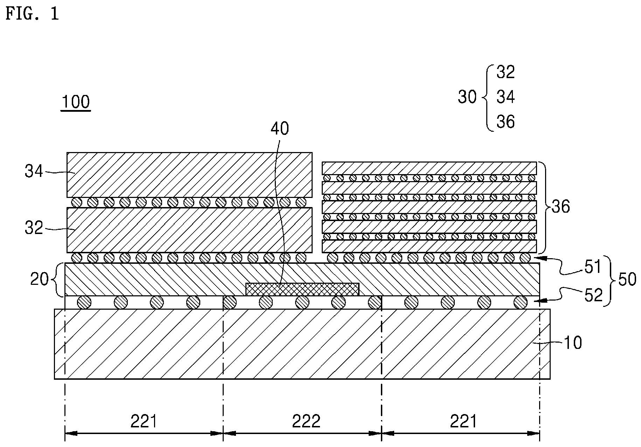

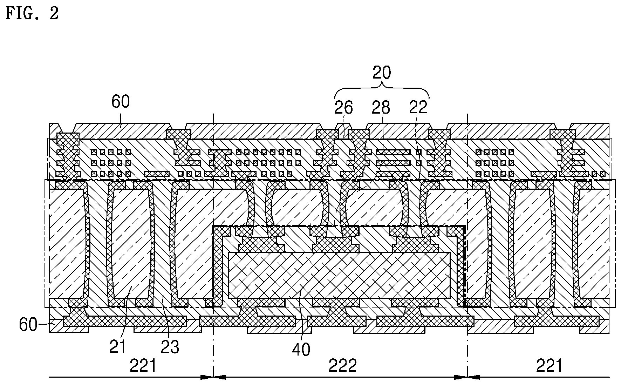

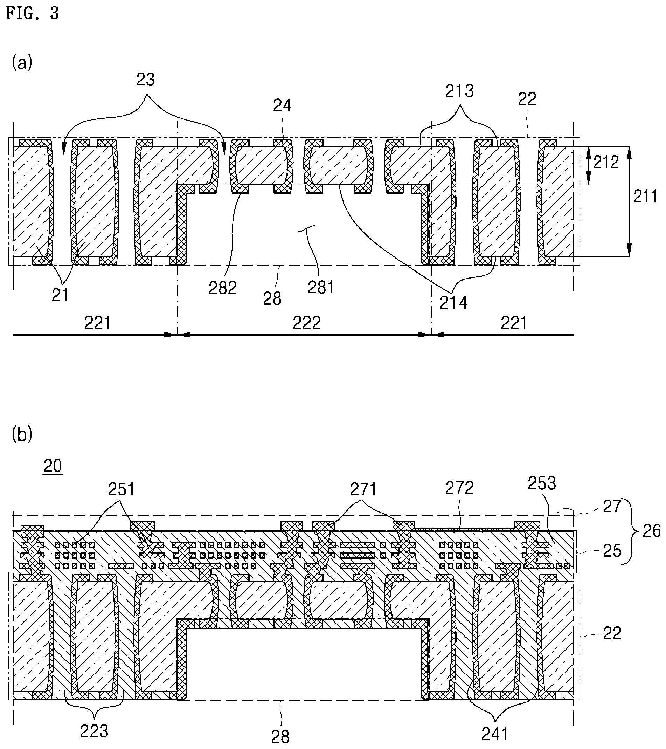

The invention is as defined in claim 1. FIG. 1 is a conceptual diagram for describing a cross-sectional structure of a packaging substrate according to an embodiment, FIG. 2 illustrates a conceptual diagram for describing a cross-sectional structure of a packaging substrate according to another embodiment, and FIGS. 3A and 3B are conceptual diagrams for respectively describing portions of the packaging substrate according to the embodiments in cross-sections.

In order to achieve the above object, a semiconductor device 100 according to the embodiment comprises a semiconductor element portion 30 in which one or more semiconductor elements 32, 34, and 36 are located, a packaging substrate 20 electrically connected to the semiconductor elements, and a motherboard 10 that is electrically connected to the packaging substrate 20, transmits an external electrical signal to the semiconductor elements 32, 34, and 36.

The packaging substrate 20 according to the present invention comprises a core layer 22, an upper layer 26 located on one surface of the core layer 22, and cavity portions 28 in which cavity elements 40 are located.

The semiconductor element portion 30 refers to elements mounted in the semiconductor device, and is mounted on the packaging substrate 20 by a connection electrode or the like. Specifically, as the semiconductor element portion 30, for example, arithmetic elements (a first element 32 and a second element 34) such as a central processing unit (CPU), a graphics processing unit (GPU), and the like, a storage element (a third element 36) such as a memory chip, and the like may be applied, but any semiconductor element mounted in a semiconductor device may be applied without limitation.

A motherboard such as a printed circuit board, a printed wiring board, or the like may be applied as the motherboard 10.

The packaging substrate 20 may selectively further comprise a lower layer (not shown) located under the core layer.

The core layer 22 comprises a glass substrate 21 comprising first regions 221 each having a first thickness 211 and a second region 222 adjacent to the first regions 221 and having a second thickness 212 thinner than the first thickness, a plurality of core vias 23 passing through the glass substrate 21 in a thickness direction, and a core distribution layer 24 that is located on a surface of the glass substrate 21 or the core via 23 and electrically connects a first surface 213 of the glass substrate 21 and a second surface 214 facing the first surface 213 through the core vias 23. That is, the core layer 22 refers to a glass structure, which is the glass substrate 21 comprising the first surface 213 and the second surface 214 facing each other, the core vias 23, and the cavity portion 28, or all of these.

The second region 222 of the core layer 22 serves as a cavity structure.

**In** the same region, the glass substrate 21 has the first surface 213 and the second surface 214 facing each other, and these two surfaces are generally parallel to each other and have uniform thicknesses throughout the glass substrate 21.

An inner space 281 formed by a thickness difference between the first region 221 and the second region 222 serves to accommodate part or all of the cavity element 40.

The glass substrate 21 comprises the core vias 23 passing through the first surfaces 213 and the second surfaces 214. The core vias 23 may be formed in both the first region 221 and the second region 222, and may be formed with an intended pitch and pattern.

Conventionally, a form in which a silicon substrate and an organic substrate are stacked was applied as a packaging substrate for a semiconductor device. **In** the case of silicon substrates, there is a concern that parasitic elements are generated when applied to a high-speed circuit due to the nature of semiconductors, and a disadvantage in that power loss is relatively large. Further, in the case of organic substrates, a large area is required to form a more complicated distribution pattern, but this does not conform to the trend of manufacturing miniaturized electronic devices. In order to form a complicated distribution pattern within a predetermined size, pattern miniaturization is substantially required, but there is a practical limit to pattern miniaturization due to the nature of materials such as polymers and the like applied to organic substrates.

In the embodiment, as a method of solving such problems, the glass substrate 21 is applied as a support of the core layer 22. Further, a packaging substrate 20 having a relatively shortened electrical flow, a relatively compact size, a faster response, and less loss characteristics is provided by applying the core vias 23 formed to pass through the glass substrates 21 along with the glass substrate 21.

As the glass substrate 21, a glass substrate applied to a semiconductor may be applied, and for example, a borosilicate glass substrate, an alkali-free glass substrate, or the like may be applied, but the present invention is not limited thereto.

The core vias 23 passes through the glass substrate 21. The core vias 23 may be formed by a method of removing predetermined regions of the glass substrate 21, and may be formed by physically and/or chemically etching plate-shaped glass.

Specifically, the formation of the core vias 23 may be performed by chemically etching or laser etching, or the like after forming defects (flaws) on the surface of the glass substrate using a method such as a laser, but the present invention is not limited thereto.

The number of core vias 23 located in the glass substrate 21 based on a unit area (1 cm x 1 cm) may be 100 to 3,000, 100 to 2,500, or 225 to 1,024. When this pitch condition is satisfied, the formation of an electrically conductive layer and the like and the performance of the packaging substrate may be improved.

The core distribution layer 24 comprises a core distribution pattern 241 which is an electrically conductive layer electrically connecting the first surface and the second surface of the glass substrate through through-vias, and a core insulating layer 223 surrounding the core distribution pattern 241. The core layer 22 may be formed with the electrically conductive layer therein through the core vias to serve as an electrical path crossing the glass substrate 21, and may connect upper and lower portions of the glass substrate with a relatively short distance to have characteristics of faster electrical signal transmission and low loss. For example, a copper-plated layer may be applied as the electrically conductive layer, but the present invention is not limited thereto.

The shape of the cavity portion 28 is substantially not limited to a shape such as a circular shape, a triangular shape, a quadrangular shape, a hexagonal shape, an octagonal shape, a cross shape, and the like.

The shape of the cavity element 40 may generally be a cylindrical shape, rectangular parallelepiped shape, or a polygonal pillar shape.

The cavity portion 28 may comprise a cavity distribution pattern, which is an electrically conductive layer electrically connecting the cavity element 40 and the core distribution layer 24, and an insulating layer which surrounds the cavity distribution pattern.

Meanwhile, a cavity portion according to another embodiment may be implemented in the form of passing through the first surface 213 and the second surface 214 of the glass substrate 21. In this case, the cavity portion may be formed according to the same process as a process of forming the core via 23, and the area and shape passing through the glass substrate 21 is different from those of the core via 23.

In this embodiment, after the cavity element 40 is arranged in the cavity portion, an insulating layer is formed. That is, the insulating layer may also be generated in the cavity portion through a process of generating the above-described core insulating layer 223.

The core distribution pattern 241 may be formed to be electrically connected to the cavity element 40.

The cavity element 40 may comprise an active element such as a transistor or a power transmission element such as a multilayer ceramic capacitor (MLCC), that is, a passive element.

When an element such as a transistor serving to convert an electrical signal between a motherboard and a semiconductor element portion to an appropriate level is applied as the cavity element 40, since a transistor or the like is applied to the path of the packaging substrate 20, a more efficient and faster semiconductor device 100 may be provided.

Further, a power transmission element such as a multilayer ceramic capacitor (MLCC) plays an important role in the performance of a semiconductor element. Generally, at least 200 or more power transmission elements, which are passive elements, are applied to a semiconductor element, and performance thereof is also affected by the characteristics of an electrically conductive layer around the element in power transmission. In one embodiment, a core via having a non-circular shape rather than a circular shape may be applied to a place where a low-resistance electrically conductive layer is required, such as a power transmission element.

Meanwhile, a passive element such as a capacitor or the like may be individually inserted into and applied to the cavity element 40, and an element group including a plurality of passive elements in the form of being embedded between insulator layers (cavity element insulating layers) may be formed such that electrodes are exposed, and then inserted into the cavity element. In the latter case, the workability of manufacturing the packaging substrate may become smoother, and there is a relative advantage in that the insulating layer is sufficiently and reliably located in a space between complicated elements.

The glass substrate 21 serves as an intermediate and intermediary, which connect the semiconductor element portion 30 and the motherboard 10 at an upper portion and a lower portion, respectively, and the core vias 23 serve as paths through which the electrical signals thereof are transmitted, and thus smoothly transmit the signals.

The upper layer 26 is located on the first surface 213.

The upper layer 26 comprises an upper distribution layer 25 and an upper surface connection layer 27 located on the upper distribution layer 25, and the uppermost surface of the upper layer 26 may be protected by a cover layer 60 formed with an opening that may come into direct contact with the connection electrode of the semiconductor element portion.

The upper distribution layer 25 comprises an upper insulating layer 253 located on the first surface, and an upper distribution pattern 251 embedded in the upper insulating layer 253 as an electrically conductive layer having a predetermined pattern and to which the core distribution layer 24 is at least partially connected.

Any one which is applied as an insulator layer in a semiconductor element or a packaging substrate may be applied as the upper insulating layer 253, for example, an epoxybased resin or the like including a filler may be applied, but the present invention is not limited thereto.

The insulator layer may be formed by a method of forming and curing a coating layer, and may also be formed by a method of laminating an insulator film formed to be a film in an uncured or semi-cured state on the core layer 22 and curing the insulator film. In this case, when a pressure sensitive lamination method or the like is applied, since the insulator is incorporated into a space in the core via 23, an efficient process may be performed.

According to one embodiment, even when multi-layer insulator layers are stacked and applied, it may become difficult to substantially distinguish the insulator layers, and a plurality of insulator layers are collectively called an upper insulation layer. Further, the same insulating material may be applied to the core insulating layer 223 and the upper insulating layer 253, and in this case, a boundary thereof may not be substantially distinguished. Alternatively, according to another embodiment, the boundary of the insulator layers may be generated by setting the pressure and temperature for curing the multi-layer insulator layers differently.

The upper distribution pattern 251 refers to an electrically conductive layer located in the upper insulating layer 253 in a preset form, and may be formed, for example, using a build-up layer method. Specifically, the upper distribution pattern 251 formed with an electrically conductive layer in a vertical direction or horizontal direction in an intended pattern may be formed by repeating a method of forming an insulator layer, removing unnecessary portions of the insulator layer, forming an electrically conductive layer by a method of copper plating or the like, selectively removing unnecessary portions of the electrically conductive layer, forming another insulator layer on the electrically conductive layer, removing the unnecessary portions again, and then forming an electrically conductive layer by a plating method or the like.

The upper distribution pattern 251 is located between the core layer 22 and the semiconductor element portion 30, and thus is formed to include a micro pattern in at least a portion thereof so that transmission of the electrical signals with the semiconductor element portion 30 may be smoothly performed and an intended complicated pattern may be sufficiently accommodated. In this case, each of a width and an interval of the micro pattern may be smaller than 4 µm, 3.5 µm or less, 3 µm or less, and 2.5 µm or less, and may be 1 to 2.3 µm (hereinafter, descriptions for the micro pattern are the same).

At least a portion of the upper surface connection layer 27 is electrically connected to the upper distribution pattern 251, and the upper surface connection layer 27 comprises an upper surface connection pattern 272 located on the upper insulating layer 253 and an upper surface connection electrode 271, which electrically connects the semiconductor element portion 30 and the upper surface connection pattern 272. The upper surface connection pattern 272 may be located on one surface of the upper insulating layer 253, and may be embedded in the upper insulating layer while at least a portion of the upper surface connection pattern 272 may be exposed on the upper insulating layer. For example, when the upper surface connection pattern is located on one surface of the upper insulating layer, the upper insulating layer may be formed by a plating method or the like, and a case in which the upper surface connection pattern is embedded in the upper insulating layer while the portion of the upper surface connection pattern is exposed on the upper insulating layer may be a case in which a portion of the insulating layer or electrically conductive layer is removed by a method such as surface polishing, surface etching, or the like after a copper-plated layer or the like is formed.

At least a portion of the upper surface connection pattern 272 may comprise a micro pattern like the above-described upper distribution pattern 251. The upper surface connection pattern 272 including the micro pattern allows a relatively larger number of elements to be connected even in a small area to make an electrical signal connection between the elements or with the outside smooth, and more integrated packaging is possible.

The upper surface connection electrode 271 may be directly connected to the semiconductor element portion 30 through a terminal or the like, and may also be connected to the semiconductor element portion 30 through an element connection portion 51 such as a solder ball.

The cavity portion 28 is located on and/or under the second region 222 and comprises a cavity distribution layer 282 electrically connected to the core distribution pattern 241 and the inner space 281 in which the cavity element 40 is located.

According to the present invention, the thickness of the glass substrate 21 in the second region 222 is thinner than the thickness of the glass substrate 21 in the first region 221, and the cavity elements 40 are located in the inner space 281 formed due to the thickness difference. Further, the core vias 23 and the core distribution layer 24 formed in the glass substrate 21 serve as an electrical connection structure connecting the cavity element 40 and external elements.

Further, as described above, in the second region 222 other than the first region 221, that is, a cavity portion in the form of passing through the first surface 213 and the second surface 214 of the glass substrate 21 is generated, and the cavity element 40 is arranged in the cavity portion.

The packaging substrate 20 is also connected to the motherboard 10. A terminal of the motherboard 10 may be directly connected to the core distribution pattern 241 located on at least a portion of the second surface 214 of the core layer 22, and the motherboard 10 may be electrically connected to the core distribution pattern 241 through a board connection portion 52 such as a solder ball. Further, the core distribution pattern 241, which comes into contact with the motherboard 10, may be connected to the motherboard 10 through a lower layer (not shown) located under the core layer 22.

Other additional substrates other than the glass substrate 21 may not be substantially applied to the packaging substrate 20 located between the semiconductor element portion 30 and the motherboard 10.

Conventionally, an interposer and an organic substrate were stacked together and applied between the element and the motherboard while connecting the element and the motherboard because a multi-stage form is applied for at least two reasons: : one is that there is a scale problem in directly bonding a micro pattern of the element to the motherboard; and the other is that a problem of wiring damage due to a difference in thermal expansion coefficient may occur during a bonding process or a process of driving the semiconductor device. **In** the embodiment, this problem was solved by applying a glass substrate having a thermal expansion coefficient similar to that of a semiconductor element, and forming a micro pattern having a sufficiently fine scale for mounting the element on the first surface and an upper layer of the glass substrate.

Hereinafter, a packaging substrate manufacturing method according to the embodiment of the present invention will be described.

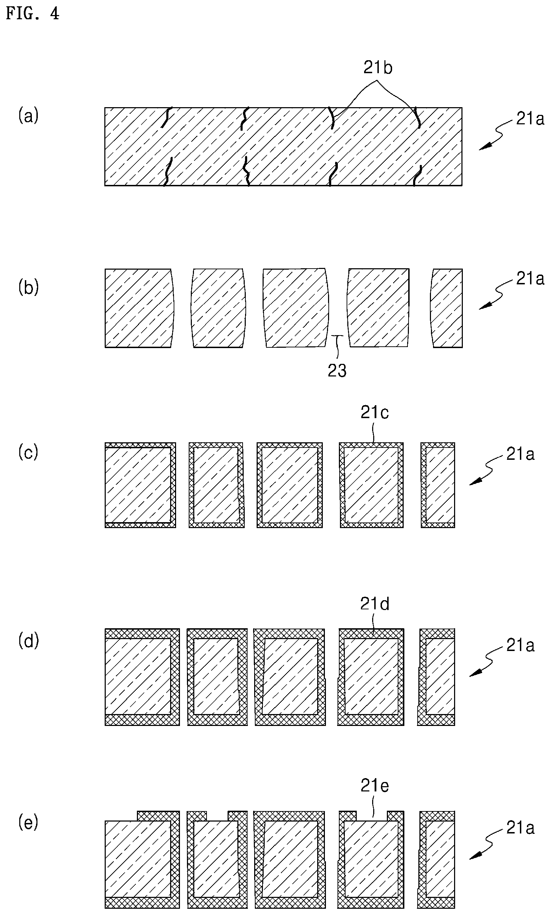

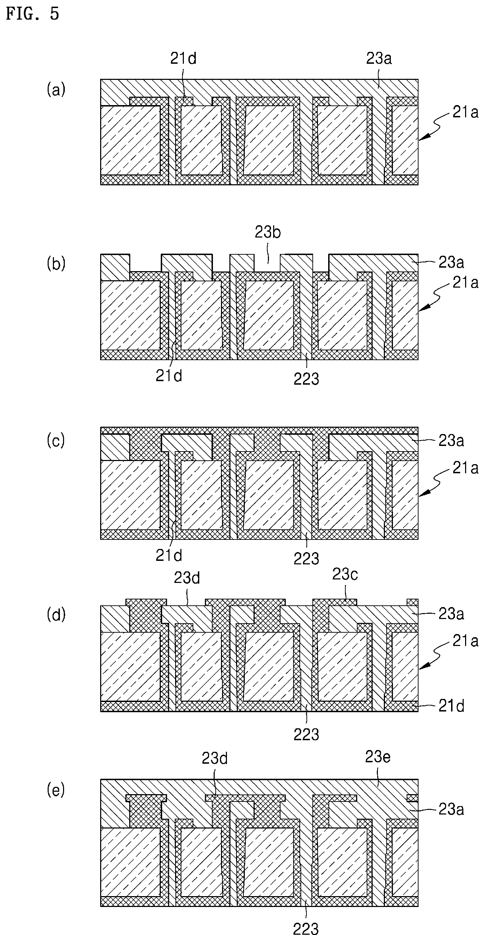

FIGS. 4 and 5 are flow charts for describing the packaging substrate manufacturing process according to the embodiment in cross-sections.

First, as shown in FIG. 4 (a), a glass substrate 21a having flat first and second surfaces is prepared, and defects (flaws) 21b are formed at predetermined positions in a glass surface to form core vias. A glass substrate applied to a substrate of an electronic device or the like may be applied as the glass substrate, for example, an alkali-free glass substrate may be applied as the glass substrate, but the present invention is not limited thereto. As commercially available products, products manufactured by manufacturers such as Corning, Schott, AGC, and the like may be applied. A method such as mechanical etching, laser irradiation, or the like may be applied to the formation of the defects (flaws).

As shown in FIG. 4 (b), in the glass substrate 21a having the defects (flaws) 21b, an etching operation of forming the core vias 23 through a physical or chemical etching process is performed. During the etching process, the vias are formed in defective portions of the glass substrate, and the surface of the glass substrate 21a is also etched. In order to prevent etching of the glass surface, a masking film or the like may be applied, but considering the inconvenience of applying and removing the masking film, the defective glass substrate itself may be etched, and in this case, the thickness of the glass substrate having the core vias may be somewhat thinner than the initial thickness of the glass substrate.

Thereafter, as shown in FIGS. 4 (c) and (d), a core layer manufacturing operation is performed by forming an electrically conductive layer 21d on the glass substrate. A metal layer including copper metal may be representatively applied as the electrically conductive layer, but the present invention is not limited thereto.

Since the surface of the glass (including the surface of the glass substrate and a surface of the core via) and the surface of the copper metal have different properties, adhesion is low. In the present invention, the adhesion between the glass surface and the metal is improved by two methods such as a dry method and a wet method.

The dry method is a method of applying sputtering, that is, a method of forming a seed layer 21c on the glass surface and an inner diameter of the core via through metal sputtering. Dissimilar metals such as titanium, chromium, and nickel is sputtered together with copper to form the seed layer, and in this case, a glass-metal adhesion may be improved by an anchor effect, in which metal particles interact with the surface morphology of the glass, or the like.

The wet method is a method of performing primer treatment, and is a method of forming a primer layer 21c by performing pre-treatment with a compound having a functional group such as an amine. The primer treatment may be performed with a compound or particles having an amine functional group after performing pre-treatment with a silane coupling agent according to the degree of intended adhesion. As mentioned above, a support substrate of the embodiment needs to have to have high enough performance to form a micro pattern, and this should be maintained even after primer treatment. Accordingly, when such a primer includes nanoparticles, nanoparticles having an average diameter of 150 nm or less may be applied, for example, nanoparticles having an amine group may be applied. The primer layer may be, for example, formed by applying a bonding strength improving agent, e.g., the CZ series manufactured by MEC or the like.

**In** the seed layer/primer layer 21c, the electrically conductive layer may selectively form the metal layer in a state in which unnecessary portions for the formation of the electrically conductive layer are removed or not removed. Further, in the seed layer/primer layer 21c, portions required or not required for the formation of the electrically conductive layer in an activated or deactivated state may be treated selectively with metal plating to perform subsequent processes. For example, light irradiation treatment such as a laser of a certain wavelength or the like, chemical treatment, or the like may be applied to the activation or deactivation treatment. A copper plating method or the like applied to semiconductor element manufacturing may be applied to the formation of the metal layer, but the present invention is not limited thereto.

As shown in FIG. 4 (e), a portion of the core distribution layer may be removed when unnecessary, and after a portion of the seed layer is removed or deactivated, metal plating may be performed to form an electrically conductive layer in a predetermined pattern, and then form an etching layer 21e of the core distribution layer.

FIG. 5 describes a manufacturing operation of forming an insulating layer and an upper distribution pattern according to one embodiment.

As shown in FIG. 5 (a), the core via may go through an insulating layer forming operation of filling an empty space with an insulating layer after forming the core distribution layer which is the electrically conductive layer. In this case, an insulating layer manufactured in the form of a film may be applied as the insulating layer to be applied, and for example, a pressure sensitive lamination method of the insulating layer in the form of a film, or the like may be applied. When the pressure sensitive lamination is performed like in this way, the insulating layer is sufficiently incorporated into the empty space in the core via to form a core insulating layer in which a void is not formed.

FIGS. 5 (b) to (e) describe an upper layer manufacturing operation.

The upper layer manufacturing operation is an operation of forming an upper distribution layer including an upper insulating layer and an upper distribution pattern on the core layer. The upper insulating layer may be formed by a method of coating a resin composition forming an insulating layer 23a or laminating insulating films, and for convenience, the method of laminating the insulating films is better. The laminating of the insulating films may be performed by a process of laminating and curing the insulating films, and in this case, when the pressure sensitive lamination method is applied, an insulating resin may be sufficiently incorporated even into a layer in which the electrically conductive layer is not formed in the core via or the like. An upper insulating layer which comes into direct contact with at least a portion of the glass substrate, and thus has sufficient adhesion is applied as the upper insulating layer. Specifically, the glass substrate and the upper insulating layer may have characteristics in which adhesion test values according to ASTM D3359 satisfy 4B or more.

The upper distribution pattern may be formed by repeating the process of forming an insulating layer 23a, and forming an electrically conductive layer 23c in a predetermined pattern and etching unnecessary portions to form an etching layer 23d of the electrically conductive layer, and electrically conductive layers formed adjacent to each other with the insulating layer therebetween may be formed by a method of performing a plating process after forming a blind via 23b in the insulating layer. A dry etching method such as laser etching, plasma etching, or the like, a wet etching method using a masking layer and an etchant, or the like may be applied to the formation of the blind via.

Hereinafter, although not shown in the drawings, an upper surface connection layer and a cover layer may be formed.

The upper surface connection pattern and the upper surface connection electrode may also be formed in a process similar to forming the upper distribution layer. Specifically, the upper surface connection pattern and the upper surface connection electrode may be formed by a method of forming an etching layer of the insulating layer on an insulating layer 23e, forming an electrically conductive layer thereon, and then forming an etching layer of the electrically conductive layer, or the like, but a method of selectively forming only the electrically conductive layer without applying an etching method may also be applied. The cover layer may be formed so that an opening (not shown) may be formed at a position corresponding to the upper surface connection electrode and thus the upper surface connection electrode is exposed, and the cover layer may be directly connected to an element connection portion, a terminal of an element, or the like.

When the upper layer is generated, a process for the lower layer may be performed by forming a lower connection layer and the cover layer. A lower distribution layer and/or the lower connection layer, and selectively, the cover layer (not shown) may be formed in a manner similar to the above-described operation of forming the upper surface connection layer and cover layer.

According to the present invention, when a plurality of elements are mounted on the glass substrate 21, at least three cavity portions 29a, 29b, and 29c having different heights may be generated in consideration of the design of the elements (that is, positions where the elements are arranged or areas or heights of the elements).

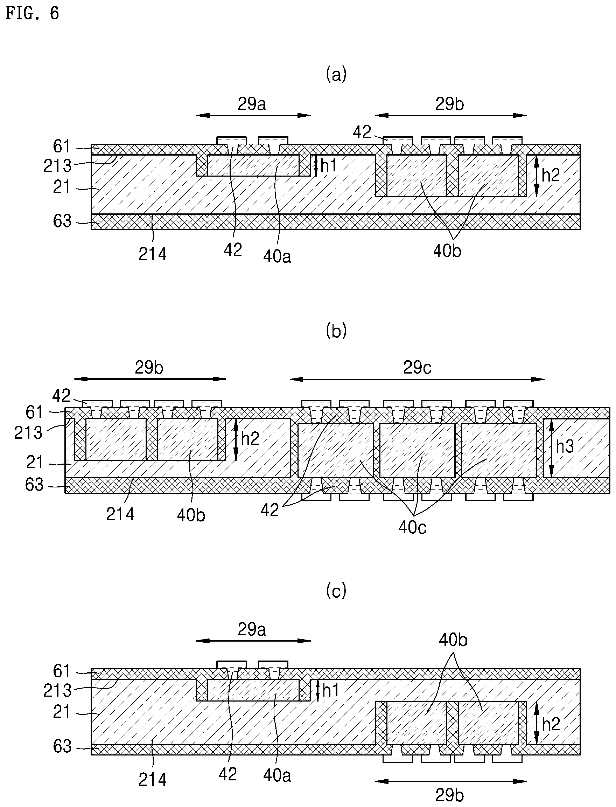

FIGS. 6 (a) to (c) are views for describing portions of the packaging substrates not covered by the present invention in cross-sections.

As shown in FIG. 6 (a), a first cavity portion 29a having a first depth h1 and a second cavity portion 29b having a second depth h2 may be formed in the glass substrate 21. Both the first cavity portion 29a and the second cavity portion 29b may be open and recessed in a direction toward the first surface 213.

The second depth h2 is deeper than the first depth h1. A cavity element portion having a height corresponding to a depth of a first cavity portion 29a may be disposed at the first cavity portion 29a, and cavity element portion having a height corresponding to a depth of a second cavity portion 29b may be disposed at the second cavity portion 29b. The cavity element portion may comprise the one in which one or two or more cavity elements 40a and 40b are arranged. The cavity element portion may be that each of cavity elements is molded one after arranged. Or the cavity element portion may be arranged one that each cavity elements are molded.

Although the cavity element portion of the first cavity portion 29a and the cavity element portion of the second cavity portion 29b have different heights, an upper insulating layer 61 formed on the first cavity portion 29a and the second cavity portion 29b may be formed substantially flat without curving.

Further, although the heights of the first cavity element 40a and the second cavity element 40b are different, the upper insulating layer 61 formed on the first cavity element 40a and the second cavity element 40b may be formed substantially flat without curving.

The insulating layer may be formed by pressure sensitive lamination of an insulating film for a semiconductor such as an Ajinomoto Build-up Film (ABF).

Due to the characteristics of the insulating film manufactured in a predetermined film shape, a deep and wide space causes a surface imbalance in a process of forming the insulating layer, and specifically, in the case of a cavity requiring the formation of an insulating layer in a space wider than a normal via, the degree of undulation may be severe.

The embodiment not covered by the present invention is intended to solve this problem by forming the depths of the cavity portions to be different so that the depths correspond to depths of the cavity elements.

A portion of the upper insulating layer 61 is incorporated into the first cavity portion 29a and the second cavity portion 29b, and a surface of the upper insulating layer 61 may be stacked substantially flat on the first surface 213. Since the depths of the first cavity portion 29a and the second cavity portion 29b are formed to be different, the first surface 213 of the glass substrate 21 may be relatively flat.

A lower insulating layer 63 may also be formed on the second surface 214 of the glass substrate 21, that is, under the glass substrate 21.

Meanwhile, one or more connection electrodes 42 may be disposed on the first cavity element 40a in the direction toward the first surface 213, and one or more connection electrodes 42 may be disposed on the second cavity element 40b in the direction toward the first surface 213.

The connection electrodes 42 are arranged or formed on the first surface 213 in a direction in which the first cavity portion 29a and the second cavity portion 29b are open, and may be electrically connected to an upper layer (not shown), which may be formed on the glass substrate 21.

The connection electrodes 42 may be formed as part of the electrodes of the first cavity element 40a and the second cavity element 40b, may be formed as distribution electrodes of the upper layer or connected to the distribution electrodes, or may be configured in the form including both above.

Meanwhile, according to another embodiment not covered by the present invention, the first cavity portion 29a and the second cavity portion 29b may be open and recessed in the direction toward the second surface 214 of the glass substrate 21 instead of the first surface 213. In this case, the connection electrodes may be disposed or formed to come into contact with the first cavity portion 29a and the second cavity portion 29b in the direction toward the second surface 214. That is, a technical feature according to the present invention is intended to generate cavity portions having different depths in the glass substrate 21, and the shape of the opening of cavity portion is irrelevant.

Further, the first surface 213 and the second surface 214 of the glass substrate 21 refer to two surfaces facing each other, and are not limited to any specific surfaces. A case in which the cavity portions are open and recessed toward the first surface may be interpreted as a case in which the cavity portions are open toward any one surface of the two facing surfaces of the glass substrate 21.

According to another embodiment not covered by the present invention, as shown in FIG. 6 (b), the core layer may comprise the second cavity portion 29b open and recessed in the direction toward the first surface 213 and having the second depth, and a third cavity portion 29c having a third depth h3 passing through the first surface 213 and the second surface 214 of the glass substrate 21. The third depth h3 is the same as the height of the glass substrate 21 and is deeper than the second depth h2 of the second cavity portion 29b recessed in only one direction.

That is, according to another embodiment not covered by the present invention, some of the cavity portions having different depths may be open in one direction of the glass substrate 21, and some of the cavity portions may be formed through the glass substrate 21.

In a third cavity element 40c mounted in the third cavity portion 29c passing through the glass substrate 21, the connection electrodes 42 may be disposed or formed on both the upper surface facing the first surface 213 and a bottom surface facing the second surface 214. That is, in the case of the third cavity element 40c passing through the glass substrate 21, one or more connection electrodes may be further disposed in a direction (on the second surface 214) opposite the connection electrodes formed on the first surface 213 with the third cavity element 40c therebetween.

The connection electrodes 42 may be electrically connected to the upper layer to supply power to a semiconductor chip, and may be electrically connected to the lower layer to be connected to the motherboard.

According to still another embodiment not covered by the present invention, as shown in FIG. 6 (c), the opening directions of a plurality of half cavities open and recessed in one direction in the glass substrate 21 may be different from each other. For example, the first cavity portion 29a may be open toward the first surface 213 and the second cavity portion 29b may be open toward the second surface 214.

As shown in the drawings, the first depth h1 of the first cavity portion 29a and the second depth h2 of the second cavity portion 29b may be different from each other, and according to an example, the second depth h2 may be deeper than the first depth h1. Of course, the first depth h1 may be deeper than the second depth h2.

In the embodiment not covered by the present invention, the connection electrodes 42, which come into contact with the first cavity element 40a, may be electrically connected to the upper layer, and the connection electrodes 42, which come into contact with the second cavity element 40b, may be electrically connected to the lower layer.

The role of the cavity elements mounted in the packaging substrate may be changed according to the design of the semiconductor element or motherboard connected to the upper layer or lower layer, and an opening direction of the cavity portions may be changed according to the role of these cavity elements. The arrangement of the connection electrodes may also be changed according to the opening direction of the cavity portions.

In the glass substrate 21, the first cavity portion 29a open and recessed in the direction toward the first surface 213 or second surface 214 and having the first depth h1may be formed, and the second cavity portion 29b having the second depth h2 different from the first depth h1 may be formed to be open in the direction toward the first surface 213 or second surface 214.

As described above, each of the cavity elements 40a, 40b, and 40c may independently be a passive element such as an MLCC or an active element such as a diode. Such various elements have different sizes, areas, or heights, and in this case, may cause undulation when a redistribution layer (RDL) is formed.

Accordingly, according to the embodiment not covered by the present invention, when a plurality of elements are mounted on the glass substrate 21, cavity portions 29a and 29b or 29b and 29c having different heights may be generated in consideration of the design of the elements (that is, the positions where the elements are arranged, the areas or heights of the elements).

To this end, a packaging substrate having cavity portions having different heights may be manufactured by repeating a method of selectively etching after masking when the cavity portions 29a and 29b or 29b and 29c are formed. However, there is a disadvantage in that the formation and removal of the masking on the surface of the glass substrate 21 should be repeatedly performed, resulting in a complicated manufacturing process.

In another method, a packaging substrate may be manufactured by selectively irradiating laser of different intensities or adjusting a laser irradiation time when the cavity portions 29a and 29b or 29b and 29c are formed, and etching the glass substrate 21 in which the cavity portions are formed. This etching may be performed in once. That is, the degree of defects formed in the substrate may be changed according to an amount of the laser irradiation, and through this process, a plurality of half cavities or full cavities having different heights may be formed. Accordingly, the problem of undulation caused by the different heights of elements when various types of elements are mounted may be alleviated or eliminated.

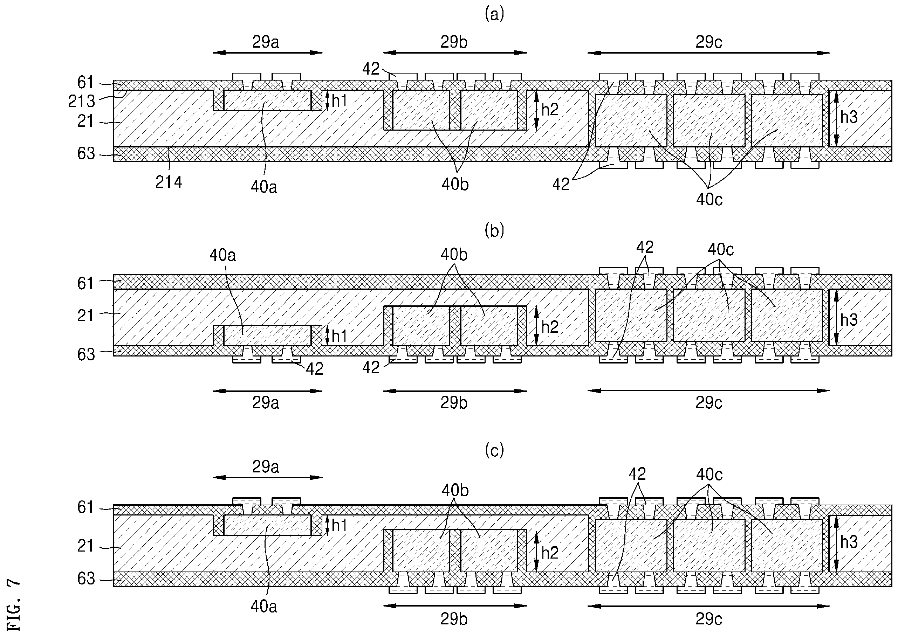

FIGS. 7 (a) to (c) are views for describing portions of the packaging substrates according to the present invention in cross-sections.

As shown in FIG. 7 (a), a first cavity portion 29a having a first depth h1, a second cavity portion 29b having a second depth h2, and a third cavity portion 29c having a third depth h3 are formed in a glass substrate 21. The first cavity portion 29a and the second cavity portion 29b are open and recessed in a direction toward a first surface 213, and the third cavity portion 29c passes through the glass substrate 21.

The second depth h2 is deeper than the first depth h1, and the third depth h3 is deeper than the second depth h2. Cavity element portions having heights respectively corresponding to the depths of the first cavity portion 29a, the second cavity portion 29b, and the third cavity portion 29c are disposed in the first cavity portion 29a, the second cavity portion 29b, and the third cavity portion 29c.

A cavity element portion of the first cavity portion 29a, a cavity element portion of the second cavity portion 29b, and a cavity element portion of the third cavity portion 29c have different heights, but an upper insulating layer 61 formed on the first cavity portion 29a, the second cavity portion 29b, and the third cavity portion 29c may be formed substantially flat without curving.

Cavity elements 40a, 40b, and 40c having heights respectively corresponding to the depths of the first cavity portion 29a, the second cavity portion 29b, and the third cavity portion 29c are disposed in the first cavity portion 29a, the second cavity portion 29b, and the third cavity portion 29c.

As shown in the drawings, the first cavity element 40a, the second cavity element 40b, and the third cavity portion 29c have different heights, but an upper insulating layer 61 formed on the first cavity element 40a, the second cavity element 40b, and the third cavity portion 29c may be formed substantially flat without curving.

A portion of the upper insulating layer 61 is incorporated into the first cavity portion 29a, the second cavity portion 29b, and the third cavity portion 29c, and a surface of the upper insulating layer 61 may be stacked substantially flat on the first surface 213. Selectively, the lower insulating layer 63 may also be formed on the second surface 214 of the glass substrate 21, that is, under the glass substrate 21.

A core layer in FIG. 7 (a) also comprises one or more connection electrodes 42 disposed on the first cavity element 40a in the direction toward the first surface 213, one or more connection electrodes 42 disposed on the second cavity element 40b in the direction toward the first surface 213, and one or more connection electrodes 42 disposed on the third cavity element 40c in the direction toward the first surface 213.

The connection electrodes 42 are arranged or formed on the first surface 213 in a direction in which the first cavity portion 29a, the second cavity portion 29b, and the third cavity portion 29c are open, and may be electrically connected to an upper layer (not shown) which may be formed on the glass substrate 21.

Additionally, in the third cavity element 40c mounted in the third cavity portion 29c passing through the glass substrate 21, the connection electrodes 42 are disposed or formed on both the upper surface facing the first surface 213 and a bottom surface facing the second surface 214. That is, in the case of the third cavity element 40c passing through the glass substrate 21, one or more connection electrodes may be further disposed in a direction (on the second surface 214) opposite the connection electrodes formed on the first surface 213 with the third cavity element 40c therebetween.

The connection electrodes 42 may be formed as part of the electrodes of the first cavity element 40a, the second cavity element 40b, and the third cavity element 40c, or may be formed as distribution electrodes of the upper layer, or may be configured in the form including both of the above.

The core layer according to the embodiment in FIG. 7 (b) comprises the cavity portions 29a, 29b, and 29c open and recessed in a direction toward the second surface 214 of the glass substrate 21, that is, the bottom surface of the glass substrate 21.

In this case, the connection electrodes 42 may be disposed or formed on bottom surfaces of the first cavity element 40a, the second cavity element 40b, and the third cavity element 40c. The connection electrodes 42 facing the bottom surfaces may be electrically connected to a motherboard (not shown) through a lower layer formed under the core layer.

According to still another embodiment, as shown in FIG. 7 (c), the opening directions of a plurality of half cavities open and recessed in one direction in the glass substrate 21 may be different from each other. For example, the first cavity portion 29a is open toward the first surface 213 and the second cavity portion 29b may be open toward the second surface 214. As shown in the drawings, the first depth h1 of the first cavity portion 29a and the second depth h2 of the second cavity portion 29b are different from each other, and , the second depth h2 is deeper than the first depth h1.

The connection electrodes 42, which come into contact with the first cavity element 40a, may be electrically connected to the upper layer, and the connection electrodes 42, which come into contact with the second cavity element 40b, may be electrically connected to the lower layer.

The role of the cavity elements mounted in the packaging substrate may be changed according to the design of the semiconductor element or motherboard connected to the upper layer or lower layer, and an opening direction of the cavity portions may be changed according to the role of these cavity elements. The arrangement of the connection electrodes may also be changed according to the opening direction of the cavity portions.

In summarization of the shape of the cavity portion in FIG. 7 (a), (b) and (c), in the glass substrate 21, the first cavity portion 29a open and recessed in the direction toward the first surface 213 or second surface 214 and having the first depth h1 is formed, the second cavity portion 29b having the second depth h2 different from the first depth h1 is formed to be open in the direction toward the first surface 213 or second surface 214, and the third cavity portion 29c passing through the first surface 213 and the second surface 214 are formed.

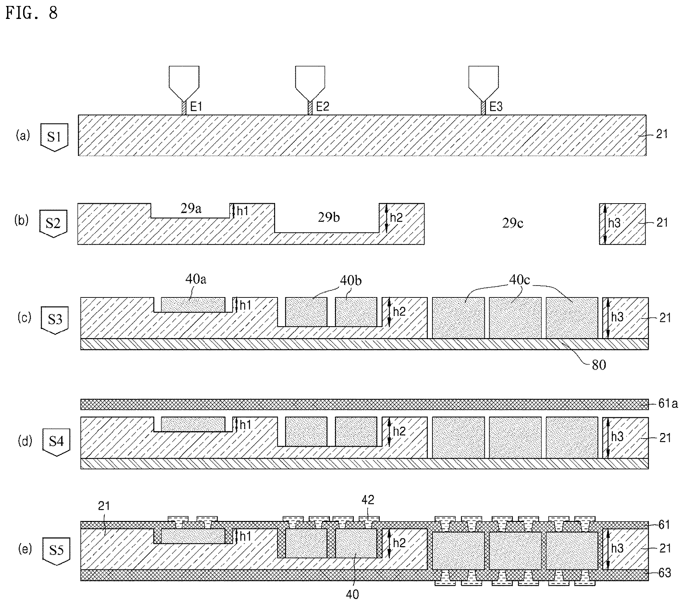

FIG. 8 is a flow chart for describing the packaging substrate manufacturing process according to the embodiment in cross-sections. A process of mounting the cavity elements and forming the core layer in the packaging substrate will be specifically viewed through FIG. 8 as follows. For example, the manufacturing process will be described with respect to a case of manufacturing a packaging substrate having three cavity portions, but the number of cavity portions or a direction of openings is not limited.

First, as shown in FIG. 8 (a), defects (or flaws) are formed on the surface of the glass substrate 21. A method such as mechanical etching, laser irradiation, or the like is applied to form the defects (or flaws), and the defects may be generated by irradiating laser (E1, E2 and E3) as shown in the drawing (S1: an operation of forming a plurality of defects).

In this case, the size of the defect, such as the width or depth, or the degree of defects may be changed according to the depth of the cavity portion. An etching rate may be fast when an intensity of defect formation is high, an etching degree may be slow when a range or the intensity of the defect formation is low, and cavity portions having different depths may be manufactured by adjusting the etching rate. Further, the etching degree may be adjusted by partially applying masking as necessary.

The size of the cavity portion may be determined to correspond to an element to be mounted in the cavity portion. That is, the degree of defects may be controlled according to the height or area of the cavity element.

When the defect is formed, as shown in FIG. 8 (b), an etching operation to forming cavity portions a first cavity portion 29a, a second cavity portion 29b, and a third cavity portion 29c is performed through a physical or chemical etching process. In etching of the cavity portions, cavity portions having different depths may be simultaneously formed by a method of immersing in an etching solution (S2: an operation of forming a cavity portion, an operation of etching).

As shown in the drawing, a depth h1 of the first cavity portion 29a is shallower than a depth h2 of the second cavity portion 29b. The third cavity portion 29c is a full cavity, and has a depth h3 the same as the height of the glass substrate 21.

Further, the area or width of the second cavity portion 29b may be greater than that of the first cavity portion 29a, and the area or width of the third cavity portion 29c may be greater than that of the second cavity portion 29b. The degree of defects and the etching degree may be adjusted according to the number of cavity elements disposed in the cavity portions.

Core vias (not shown in FIG. 8) are generated in the glass substrate 21 through defect generation and the etching process. The core vias may be formed through the same process as the cavity portion or an independent process.

Although not shown in the drawing, after the etching process, an electrically conductive layer is formed on a surface of glass (including the surface of the glass substrate, the surface of the cavity portion, and a surface of the core via). As the electrically conductive layer, a metal layer including copper metal may be typically applied, but the present invention is not limited thereto. A dry method implemented by applying sputtering, a wet method implemented by performing primer treatment, or the like are used for the electrically conductive layer.

After the above process, as shown in FIG. 8 (c), the glass substrate 21 may be attached to an adhesive film such as a polyimide tape (PI tape), and cavity elements (40a, 40b, and 40c) may be selected and disposed in the cavity portions (29a, 29b, and 29c). (S3: an operation of arranging).

As shown in the drawings, the first cavity elements 40a disposed in the first cavity portion 29a has a smaller height than the second cavity elements 40b or the third cavity elements 40c, and the third cavity elements 40c has the largest height. That is, since the cavity portions are created according to the heights or sizes of the cavity elements and the cavity elements are disposed according to the heights, the upper surface of the glass substrate 21 has a substantially flat shape with less curvature than a difference in height of the cavity elements despite the difference in height of the cavity elements.

Thereafter, as shown in FIG. 8 (d), a lamination process (lamination on top) is performed on the first surface to form an insulating layer (S4: an operation of forming an insulating layer). When an insulating film such as an Ajinomoto Build-up Film (ABF) is laminated on the entire first surface of the glass substrate 21 and curing is performed, an insulator may be incorporated into inner spaces of the cavity portions (29a, 29b, and 29c). According to this embodiment, as shown in FIG. 8 (e), the upper insulating layer may be formed in a relatively flat shape in which curving, i.e., undulation, does not substantially occur.

According to an example, the insulating layer may be formed through a plurality of lamination processes. That is, a process of laminating and curing the insulating film may be performed not once but twice or more to improve the warpage phenomenon of the glass substrate, and prevent separation or detachment of the cavity elements.

The adhesive film may be removed during subsequent processes as necessary. For example, the adhesive film may be an adhesive film whose adhesive force may be reduced by irradiation with ultraviolet light or the like. The adhesive force of the adhesive film may be reduced by radiating ultraviolet rays to the adhesive film directly or through the glass core, or the like, and the adhesive film may be easily removed from the glass core.

After the insulating layer is formed on the first surface of the glass substrate 21, as shown in FIG. 8 (e), a lower insulating layer may also be formed on the surface of the second surface, and connection electrodes 42 electrically connected to the cavity elements the cavity elements may be formed.

Thereafter, an upper layer (not shown) may be formed on the glass substrate 21, and a lower layer (not shown) may be formed under the glass substrate 21.

Since a process of forming the upper layer and the lower layer is substantially the same as that described with reference to FIGS. 5 (a) to (e), overlapping descriptions will be omitted.

The packaging substrate according to the present invention may compactly mount elements having various shapes and sizes in the glass substrate, and may alleviate or eliminate undulation, which may occur in the core layer.

The packaging substrate according to the present invention can alleviate undulation, which occurs when various types of elements are mounted.

Further, the present invention provides a packaging substrate and a method of manufacturing the same capable of forming an overall flat core layer even when elements having various heights are mounted in a glass substrate.

**In** addition, according to the present invention, a flat insulating layer and an upper layer formed on the insulating layer can be formed on a glass substrate when a core layer becomes flat due to cavity structures having various heights.

## Claims

1. A packaging substrate (20) comprising:
a core layer (22),
wherein the core layer (22) comprises:
a glass substrate (21) comprising a first surface (213) and a second surface (214) facing each other;
a core via (23) formed in the glass substrate;
at least two or more cavity portions (28) each having an opening open in a direction toward the first surface (213) or in a direction toward the second surface (214), wherein the cavity portions (28) comprises:
a first cavity portion (29a) open and recessed in a direction toward the first surface (213) and having a first depth (h1);
a second cavity portion (29b) open and recessed in the direction toward the first surface (213) or the second surface (214) and having a second depth (h2); and
a third cavity portion (29c) having a third depth (h3) passing through the first surface (213) and the second surface (214), and
the second depth (h2) is deeper than the first depth (h1);
an electrically conductive layer formed on the surface of the glass substrate (21), a surface of the cavity portion (28), and a surface of the core via (23), wherein the conductive layer comprises a seed layer (21c) formed by sputtering dissimilar metals comprising titanium, chromium, or nickel together with copper, or a primer layer (21c) formed by pre-treatment with a compound having a functional group of an amine; and
cavity elements (40), wherein the cavity elements comprise:
a first cavity element (40a) arranged in the first cavity portion (29a), a second cavity element (40b) arranged in the second cavity portion (29b), and a third cavity element (40c) arranged in the third cavity portion (29c),
wherein one or more connection electrodes (42) are disposed on the first cavity element (40a), one or more connection electrodes (42) are disposed on the second cavity element (40b), and one or more connection electrodes (42) are disposed on the third cavity element (40c) in the direction toward the first surface or the second surface.

2. The packaging substrate (20) of claim 1, wherein the cavity elements arranged in the cavity portions (28) have different heights; and
an insulating layer incorporated into the cavity portions (28), and formed on a surface of the glass substrate (21) formed with the opening.

3. The packaging substrate (20) of claim 1, wherein one or more connection electrodes are further disposed in a direction opposite the connection electrodes with the third cavity element (40c).

4. A method of manufacturing a packaging substrate (20), comprising:
an operation of forming a plurality of defects of different degrees on a first surface (213) and a second surface (214) of a glass substrate (21) comprising the first and second surfaces facing each other;
an operation of etching the glass substrate (21) to form a core via (23) and at least two or more cavity portions (28) having different depths, wherein the cavity portions comprise a first cavity portion (29a), a second cavity portion (29b) and a third cavity portion (29c), wherein the first cavity portion (29a) is open and recessed in the direction toward the first surface (213) and has a first depth (h1), the second cavity portion (29b) is open and recessed in the direction toward the first surface (213) or the second surface (214) and has a second depth (h2), and the third cavity portion (29c) has a third depth (h3) passing through the first surface (213) and the second surface (214), and the second depth (h2) is deeper than the first depth (h1),
an operation of forming an electrically conductive layer (21d) on the surface of the glass substrate (21), a surface of the cavity portion (28), and a surface of the core via (23), wherein the electrically conductive layer (21d) comprises a seed layer (21c) formed by sputtering dissimilar metals including titanium, chromium, or nickel together with copper, or a primer layer (21c) formed by performing pre-treatment with a compound having a functional group of an amine,
an operation of arranging cavity elements and an operation of forming an insulating layer after the operation of forming the cavity portion, wherein the cavity element comprises a first cavity element (40a) arranged in the first cavity portion, a second cavity element (40b) arranged in the second cavity portion, and a third cavity element (40c) arranged in the third cavity portion, and
an operation of forming, wherein the operation of forming forms one or more connection electrodes (42) connected to the first cavity element (40a), one or more connection electrodes (42) connected to the second cavity element (40b), and one or more connection electrodes (42) connected to the third cavity element (40c),
wherein the operation of arranging cavity elements arranges the cavity elements having different heights in the cavity portions, and the operation of forming an insulating layer forms the insulating layer on a surface of the cavity portion (28) formed with an opening.

5. The method of claim 4, wherein the insulating layer is formed through a plurality of lamination processes.

6. The method of claim 4, wherein one or more connection electrodes (42) are further formed in a direction opposite the connection electrodes with the third cavity element therebetween.

## Patentansprüche

1. Verpackungssubstrat (20), umfassend:
eine Kernschicht (22),
wobei die Kernschicht (22) umfasst:
ein Glassubstrat (21), das eine erste Oberfläche (213) und eine zweite Oberfläche (214) umfasst, die einander zugewandt sind;
eine Kerndurchkontaktierung (23), die in dem Glassubstrat ausgebildet ist;
zumindest zwei oder mehr Hohlraumabschnitte (28), die jeweils eine Öffnung aufweisen, die in Richtung der ersten Oberfläche (213) oder in Richtung der zweiten Oberfläche (214) offen ist, wobei die Hohlraumabschnitte (28) umfassen:
einen ersten Hohlraumabschnitt (29a), der in Richtung der ersten Oberfläche (213) offen und vertieft ist und eine erste Tiefe (h1) aufweist;
einen zweiten Hohlraumabschnitt (29b), der in Richtung der ersten Oberfläche (213) oder der zweiten Oberfläche (214) offen und vertieft ist und eine zweite Tiefe (h2) aufweist; und
einen dritten Hohlraumabschnitt (29c), der eine dritte Tiefe (h3) aufweist und sich durch die erste Oberfläche (213) und die zweite Oberfläche (214) erstreckt, und
wobei die zweite Tiefe (h2) tiefer als die erste Tiefe (h1) ist;
eine elektrisch leitfähige Schicht, die auf der Oberfläche des Glassubstrats (21), einer Oberfläche des Hohlraumabschnitts (28) und einer Oberfläche der Kerndurchkontaktierung (23) ausgebildet ist, wobei die leitfähige Schicht eine Keimschicht (21c), die durch Sputtern unterschiedlicher Metalle, die Titan, Chrom oder Nickel umfassen, zusammen mit Kupfer gebildet wird, oder eine Primerschicht (21c), die durch eine Vorbehandlung mit einer Verbindung, die eine funktionelle Gruppe eines Amins aufweist, gebildet wird, umfasst; und
Hohlraumelemente (40), wobei die Hohlraumelemente umfassen:
ein erstes Hohlraumelement (40a), das in dem ersten Hohlraumabschnitt (29a) angeordnet ist, ein zweites Hohlraumelement (40b), das in dem zweiten Hohlraumabschnitt (29b) angeordnet ist, und ein drittes Hohlraumelement (40c), das in dem dritten Hohlraumabschnitt (29c) angeordnet ist,
wobei eine oder mehrere Verbindungselektroden (42) auf dem ersten Hohlraumelement (40a), eine oder mehrere Verbindungselektroden (42) auf dem zweiten Hohlraumelement (40b) und eine oder mehrere Verbindungselektroden (42) auf dem dritten Hohlraumelement (40c) in Richtung der ersten Oberfläche oder der zweiten Oberfläche angeordnet sind.

2. Verpackungssubstrat (20) nach Anspruch 1, wobei die in den Hohlraumabschnitten (28) angeordneten Hohlraumelemente unterschiedliche Höhen aufweisen; und
eine Isolierschicht, die in die Hohlraumabschnitte (28) eingebracht und auf einer Oberfläche des mit der Öffnung versehenen Glassubstrats (21) ausgebildet ist.

3. Verpackungssubstrat (20) nach Anspruch 1, wobei eine oder mehrere Verbindungselektroden weiterhin in einer den Verbindungselektroden des dritten Hohlraumelements (40c) entgegengesetzten Richtung angeordnet sind.

4. Verfahren zur Herstellung eines Verpackungssubstrats (20), umfassend:
einen Vorgang des Ausbildens einer Mehrzahl von Defekten unterschiedlichen Ausmaßes auf einer ersten Oberfläche (213) und einer zweiten Oberfläche (214) eines Glassubstrats (21), das eine erste Oberfläche (213) und eine dieser gegenüberliegende zweite Oberfläche (214) aufweist;
einen Vorgang des Ätzens des Glassubstrats (21), um eine Kerndurchkontaktierung (23) und zumindest zwei oder mehr Hohlraumabschnitte (28) mit unterschiedlichen Tiefen auszubilden, wobei die Hohlraumabschnitte einen ersten Hohlraumabschnitt (29a), einen zweiten Hohlraumabschnitt (29b) und einen dritten Hohlraumabschnitt (29c) umfassen, wobei der erste Hohlraumabschnitt (29a) in Richtung der ersten Oberfläche (213) offen und vertieft ist und eine erste Tiefe (h1) aufweist, der zweite Hohlraumabschnitt (29b) in Richtung der ersten Oberfläche (213) oder der zweiten Oberfläche (214) offen und vertieft ist und eine zweite Tiefe (h2) aufweist und der dritte Hohlraumabschnitt (29c) eine dritte Tiefe (h3) aufweist und sich durch die erste Oberfläche (213) und die zweite Oberfläche (214) erstreckt, und die zweite Tiefe (h2) tiefer als die erste Tiefe (h1) ist, einen Vorgang des Ausbildens einer elektrisch leitfähigen Schicht (21d) auf der Oberfläche des Glassubstrats (21), einer Oberfläche des Hohlraumabschnitts (28) und einer Oberfläche der Kerndurchkontaktierung (23), wobei die elektrisch leitfähige Schicht (21d) eine Keimschicht (21c), die durch Sputtern unterschiedlicher Metalle, die Titan, Chrom oder Nickel umfassen, zusammen mit Kupfer gebildet wird, oder eine Primerschicht (21c), die durch Durchführen einer Vorbehandlung mit einer Verbindung, die eine funktionelle Gruppe eines Amins aufweist, gebildet wird, umfasst,
einen Vorgang des Anordnens von Hohlraumelementen und einen Vorgang des Ausbildens einer Isolierschicht nach dem Vorgang des Ausbildens des Hohlraumabschnitts, wobei das Hohlraumelement ein erstes Hohlraumelement (40a), das in dem ersten Hohlraumabschnitt angeordnet ist, ein zweites Hohlraumelement (40b), das in dem zweiten Hohlraumabschnitt angeordnet ist, und ein drittes Hohlraumelement (40c), das in dem dritten Hohlraumabschnitt angeordnet ist, umfasst, und
einen Vorgang des Ausbildens, wobei der Vorgang des Ausbildens eine oder mehrere Verbindungselektroden (42), die mit dem ersten Hohlraumelement (40a) verbunden sind, eine oder mehrere Verbindungselektroden (42), die mit dem zweiten Hohlraumelement (40b) verbunden sind, und eine oder mehrere Verbindungselektroden (42), die mit dem dritten Hohlraumelement (40c) verbunden sind, ausbildet,
wobei der Vorgang des Anordnens von Hohlraumelementen die Hohlraumelemente mit unterschiedlichen Höhen in den Hohlraumabschnitten anordnet und der Vorgang des Ausbildens einer Isolierschicht die Isolierschicht auf einer Oberfläche des mit einer Öffnung versehenen Hohlraumabschnitts (28) ausbildet.

5. Verfahren nach Anspruch 4, wobei die Isolierschicht durch eine Mehrzahl von Laminierungsprozessen ausgebildet wird.

6. Verfahren nach Anspruch 4, wobei eine oder mehrere Verbindungselektroden (42) weiterhin in einer Richtung entgegengesetzt zu den Verbindungselektroden ausgebildet werden, wobei sich das dritte Hohlraumelement dazwischen befindet.

## Revendications

1. Substrat d'encapsulation (20) comprenant :
une couche de noyau (22),
la couche de noyau (22) comprend :
un substrat en verre (21) comprenant une première surface (213) et une deuxième surface (214) se faisant face ;
un trou d'interconnexion de noyau (23) formé dans le substrat en verre ;
au moins deux parties de cavité (28) ayant chacune une ouverture vers la première surface (213) ou vers la deuxième surface (214), lesdites parties de cavité (28) comprenant :
une première partie de cavité (29a) ouverte, ménagée vers la première surface (213) et ayant une première profondeur (h1) ;
une deuxième partie de cavité (29b) ouverte, ménagée vers la première surface (213) ou la deuxième surface (214) et ayant une deuxième profondeur (h2) ; et
une troisième partie de cavité (29c) ayant une troisième profondeur (h3), traversant la première surface (213) et la deuxième surface (214), et
la deuxième profondeur (h2) étant supérieure à la première profondeur (h1) ;
une couche conductrice électrique formée sur la surface du substrat en verre (21), une surface de la partie de cavité (28) et une surface du trou d'interconnexion de noyau (23), la couche conductrice comprenant une couche d'ensemencement (21c) formée par pulvérisation cathodique de métaux dissemblables contenant du titane, du chrome, ou du nickel avec du cuivre, ou une couche primaire (21c) formée par prétraitement avec un composé ayant un groupe fonctionnel d'une amine ; et
des éléments de cavité (40), lesdits éléments de cavité comprenant :
un premier élément de cavité (40a) disposé dans la première partie de cavité (29a), un deuxième élément de cavité (40b) disposé dans la deuxième partie de cavité (29b), et un troisième élément de cavité (40c) disposé dans la troisième partie de cavité (29c),
où une ou plusieurs électrodes de connexion (42) sont disposées sur le premier élément de cavité (40a), une ou plusieurs électrodes de connexion (42) sont disposées sur le deuxième élément de cavité (40b), et une ou plusieurs électrodes de connexion (42) sont disposées sur le troisième élément de cavité (40c) dans la direction de la première surface ou de la deuxième surface.

2. Substrat d'encapsulation (20) selon la revendication 1, où les éléments de cavité disposés dans les parties de cavité (28) sont de hauteurs différentes ; et
une couche isolante est incorporée dans les parties de cavité (28), et est formée sur une surface du substrat en verre (21) formée avec l'ouverture.

3. Substrat d'encapsulation (20) selon la revendication 1, où une ou plusieurs électrodes de connexion sont en outre disposées dans une direction opposée aux électrodes de connexion avec le troisième élément de cavité (40c).

4. Procédé de fabrication d'un substrat d'encapsulation (20), comprenant :
une opération de formation d'une pluralité de défauts de différents degrés sur une première surface (213) et une deuxième surface (214) d'un substrat en verre (21) comprenant la première et la deuxième surfaces se faisant face ;
une opération de gravure du substrat en verre (21) pour former un trou d'interconnexion de noyau (23) et au moins deux parties de cavité (28) de profondeurs différentes, lesdites parties de cavité comprenant une première partie de cavité (29a), une deuxième partie de cavité (29b) et une troisième partie de cavité (29c), la première partie de cavité (29a) étant ouverte, ménagée vers la première surface (213) et ayant une première profondeur (h1), la deuxième partie de cavité (29b) étant ouverte, ménagée vers la première surface (213) ou la deuxième surface (214) et ayant une deuxième profondeur (h2), et la troisième partie de cavité (29c) ayant une troisième profondeur (h3) traversant la première surface (213) et la deuxième surface (214), la deuxième profondeur (h2) étant supérieure à la première profondeur (h1), une opération de formation d'une couche conductrice électrique (21d) sur la surface du substrat en verre (21), une surface de la partie de cavité (28) et une surface du trou d'interconnexion de noyau (23), ladite couche conductrice électrique (21d) comprenant une couche d'ensemencement (21c) formée par pulvérisation cathodique de métaux dissemblables contenant du titane, du chrome, ou du nickel avec du cuivre, ou une couche primaire (21c) formée par prétraitement avec un composé ayant un groupe fonctionnel d'une amine,
une opération d'agencement d'éléments de cavité et une opération de formation d'une couche isolante après l'opération de formation de la partie de cavité, lesdits éléments de cavité comprenant un premier élément de cavité (40a) disposé dans la première partie de cavité, un deuxième élément de cavité (40b) disposé dans la deuxième partie de cavité, et un troisième élément de cavité (40c) disposé dans la troisième partie de cavité, et
une opération de formage, ladite opération de formage formant une ou plusieurs électrodes de connexion (42) connectées au premier élément de cavité (40a), une ou plusieurs électrodes de connexion (42) connectées au deuxième élément de cavité (40b), et une ou plusieurs électrodes de connexion (42) connectées au troisième élément de cavité (40c),
où l'opération d'agencement d'éléments de cavité dispose les éléments de cavité ayant différentes hauteurs dans les parties de cavité, et l'opération de formation d'une couche isolante forme la couche isolante sur une surface de la partie de cavité (28) formée avec une ouverture.

5. Procédé selon la revendication 4, où la couche isolante est formée au moyen d'une pluralité de processus de stratification.

6. Procédé selon la revendication 4, où une ou plusieurs électrodes de connexion (42) sont en outre formées dans une direction opposée aux électrodes de connexion, le troisième élément de cavité étant intercalé entre celles-ci.
